# FASCICULE DE BREVET EUROPEEN

(11) **EP 3 201 843 B1**
(45) Date de publication et mention de la délivrance du brevet: **04.03.2020**
(21) Numéro de dépôt: 15788471.9
(22) Date de dépôt: 30.09.2015
(51) Int. Cl.: G06K 19/077

(54) **PROCÉDÉ DE FABRICATION DE CARTE À PUCE ET CARTE À PUCE OBTENUE PAR CE PROCÉDÉ.**
CHIPKARTENHERSTELLUNGSVERFAHREN UND DURCH BESAGTES VERFAHREN ERHALTENE CHIPKARTE
CHIP CARD MANUFACTURING METHOD, AND CHIP CARD OBTAINED BY SAID METHOD

(30) Priorité: 30.09.2014 FR 1459310
(43) Date de publication de la demande: 09.08.2017
(73) Titulaire: Linxens Holding, 78200 Mantes-la-Jolie (FR)
(72) Inventeur: EYMARD, Eric, F-43000 Polignac (FR); PROYE, Cyril, F-78200 Magnanville (FR); GUERINEAU, Nicolas, F-95300 Pontoise (FR); PAUL, Christophe, 27940 Courcelles sur Seine (FR)
(74) Mandataire: Regi, François-Xavier
(86) Numéro de dépôt international: PCT/FR2015/052621
(87) Numéro de publication internationale: WO 2016/051092

(56) Documents cités:
- EP-A1- 2 541 471
- DE-A1- 19 709 985
- FR-A1- 2 753 819
- FR-A1- 2 863 747
- FR-A1- 2 938 380
- JP-A- 2011 107 865

## Description

L'invention concerne le domaine des cartes à puces. Les cartes à puce sont bien connues du public, qui en a de multiples usages : cartes de paiement, cartes SIM pour téléphones portables, cartes de transport, cartes d'identité, etc.

Les cartes à puce comportent des moyens de transmission pour transmettre des données d'une puce électronique (circuit intégré) à un dispositif lecteur de carte (lecture) ou de ce dispositif à la carte (écriture). Ces moyens de transmission peuvent être « à contact », « sans contact » ou bien à double-interface lorsqu'ils combinent les deux précédents moyens. L'invention permet de réaliser en particulier des cartes à puce à double interface. Les cartes à puce à double interface sont appelées « dual » si les modes « avec contact » et « sans contact » sont gérés par une seule puce ou « hybrides » si les modes « avec contact » et « sans contact » sont gérés par deux puces physiquement distinctes.

Les cartes à puce à double interface sont généralement constituées d'un support rigide en matière plastique de type PVC, PVC/ABS, PET ou polycarbonate constituant l'essentiel de la carte, dans lequel sont incorporés un module électronique et une antenne fabriqués séparément. Le module électronique comporte un circuit imprimé généralement flexible muni d'une puce électronique et des plages de contacts électriquement connectées à la puce et affleurant sur le module électronique, en surface du support constitutif de la carte, pour une connexion par contact électrique avec un dispositif lecteur de carte. Les cartes à puce à double interface comportent en outre au moins une antenne pour transmettre des données entre la puce et un système radiofréquence permettant la lecture ou l'écriture des données, sans contact.

Le document DE19709985A1 divulgue ainsi une carte à puce correspondant au préambule de la revendication 20.

Dans l'art antérieur, le module électronique comprenant les contacts et la puce, d'une part, et l'antenne éventuellement intégrée à un support (« inlay » selon la terminologie anglo-saxonne), d'autre part, sont généralement fabriqués séparément, puis l'antenne est connectée au module sur lequel est montée et connectée la puce. La connexion entre l'antenne et le module est réalisée selon des procédés complexes qui impactent négativement la productivité, les rendements de fabrication et la fiabilité des cartes lors de leur utilisation.

Un but de l'invention est de simplifier et de fiabiliser ce type de procédés.

Ce but est au moins en partie atteint grâce à un procédé de fabrication d'une carte à puce conforme à la revendication 1.

Le dépôt de matériau de soudure ou brasure (par exemple constitué d'un alliage d'étain-bismuth), par exemple sous forme de gouttes, sur les plots de connexion de l'antenne permet de réaliser un produit support d'antenne (« inlay » avec une antenne) qui peut être commercialisé tel quel afin d'être encarté dans des couches de matière plastique et connecté à un module monté dans la carte ultérieurement. Ce produit est prêt à l'emploi et facilite les opérations du fabricant de cartes. En effet, ce fabricant de carte n'a plus qu'à assembler des éléments (« inlay » avec une antenne, module et feuilles de matière plastique) fournis éventuellement séparément. L'opération de connexion du module à l'antenne est extrêmement simplifiée par l'utilisation du matériau de soudure déjà en place sur les plots de connexion de l'antenne. En outre, cette opération peut être concomitante de celle consistant à fixer ou coller le module dans sa cavité, soit seulement à l'aide du matériau de soudure lui-même, soit à l'aide d'un matériau de collage tel qu'un adhésif thermo-réactivable, une seule opération de chauffage étant alors nécessaire pour à la fois connecter le module à l'antenne et fixer le module dans sa cavité.

Par ailleurs, un module double-face (c'est-à-dire avec des contacts sur une face et des pistes conductrices sur l'autre) peut être réalisé et commercialisé également séparément. La connexion de l'antenne à la puce est réalisée via la soudure entre les plots de connexion de l'antenne et les pistes conductrices de la face arrière du module.

De manière complémentaire, les gouttes de matériau de soudure sont éventuellement également déposées sur les pistes conductrices du module dédiées à la connexion de l'antenne.

Le procédé selon l'invention comporte éventuellement l'une ou l'autre des caractéristiques des revendications 2 à 14, prise séparément ou en combinaison.

Le procédé selon l'invention peut être mis en œuvre en continu (« reel-to-reel » selon la terminologie anglo-saxonne).

Selon un autre aspect l'invention est un support d'antenne pour carte à puce selon l'une des revendications 15 à 19.

Selon encore un autre aspect, l'invention est une carte à puce selon l'une des revendications 20 à 27.

D'autres caractéristiques et avantages de l'invention apparaîtront à la lecture de la description détaillée et des dessins annexés sur lesquels :
- La figure 1 représente schématiquement en perspective un empilement des couches constitutives d'une structure pour carte à puce ;
- La figure 2 représente schématiquement en transparence, une portion de bande de support d'antennes,
- La figure 3 représente schématiquement, en transparence, un agrandissement d'une zone de la bande de la figure 2 comportant une antenne ;
- La figure 4 représente schématiquement, en transparence, une zone découpée dans une couche placée sur la zone de la figure 3 ;
- la figure 5 représente schématiquement, en transparence, un agrandissement de la zone découpée de la figure 4 ;
- La figure 6 représente schématiquement, en transparence, la zone découpée des figures 3 et 4, avec un module logé dans cette zone découpée ;
- La figure 7 représente schématiquement en coupe un exemple de carte à puce obtenue par le procédé ;
- La figure 8 représente schématiquement un agrandissement d'une zone de la carte à puce de la figure 7 ;
- La figure 9 représente un autre exemple de carte à puce obtenue par le procédé ;
- la figure 10 représente schématiquement une portion en coupe d'un autre exemple de carte à puce obtenue selon un autre procédé ;
- la figure 11 représente schématiquement en perspective différentes étapes d'un procédé de réalisation d'une unité de soudure et fixation, pour l'exécution d'un autre mode de mise en œuvre du procédé selon l'invention ;
- la figure 12 représente schématiquement en perspective un module utilisable avec une unité de soudure telle que celle illustrée sur la figure 11 ;
- la figure 13 représente schématiquement un support d'antenne intégrant une unité de soudure telle que celle illustrée sur la figure 11 ; et
- la figure 14 représente schématiquement en perspective une portion d'un support d'antenne tel que celui représenté sur la figure 13, inséré dans une structure de carte, et après fraisage de la cavité recevant un module tel que celui illustré sur la figure 12.

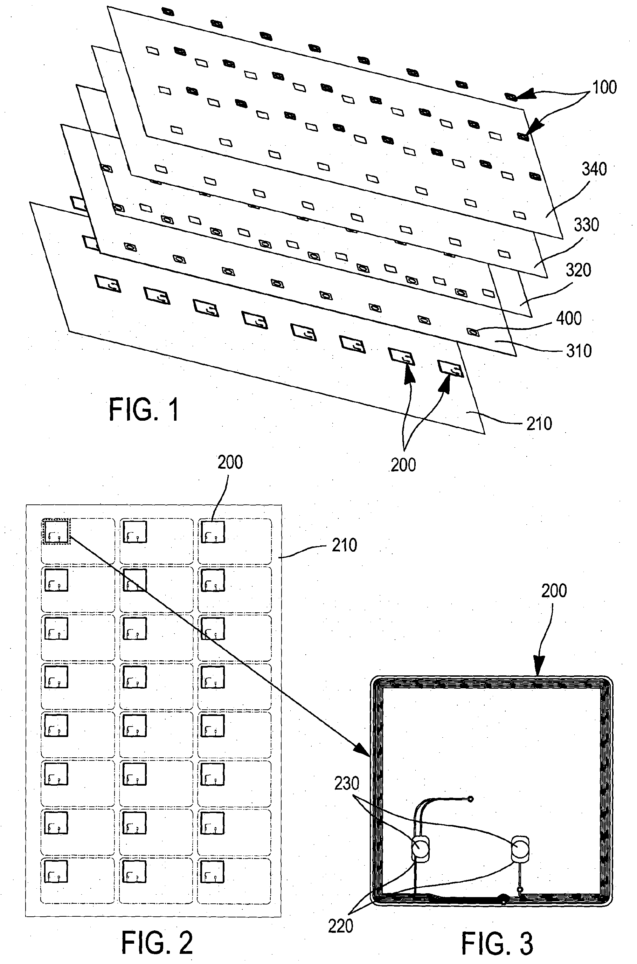

Selon un mode de mise en œuvre du procédé de fabrication de carte à puce, on réalise d'une part, des modules 100, et d'autre part, des antennes 200 sur un support 210 (voir figure 1).

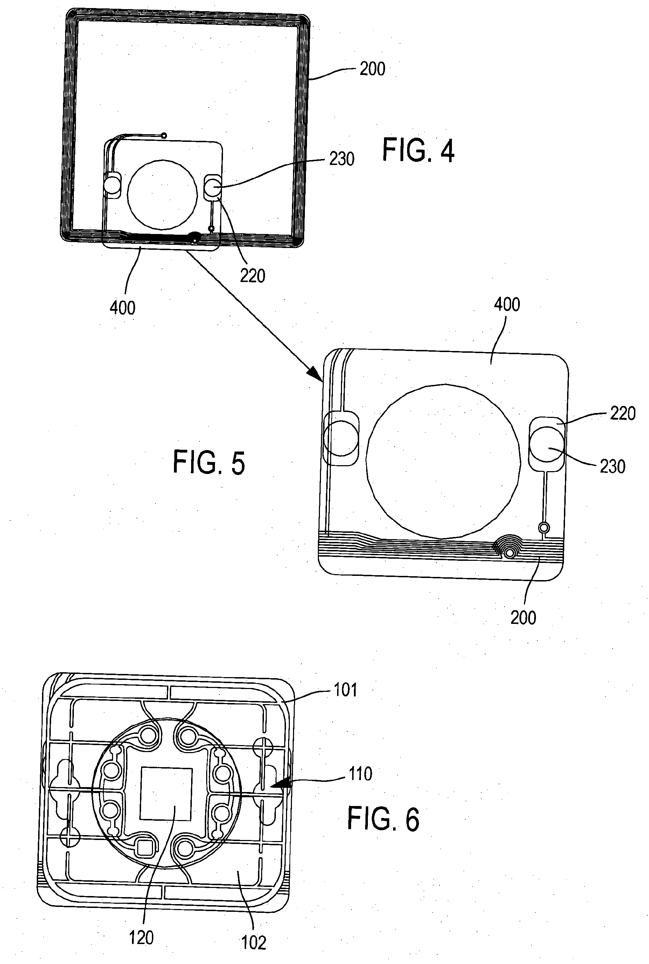

Comme représenté sur la figure 6 (en transparence, c'est-à-dire en représentant les motifs présents sur les deux faces du substrat 101), chaque module 100 est réalisé, par exemple de manière connue, sur un substrat 101 double face comportant des contacts 102, sur une face (appelée « face contact » ou « face avant »), ainsi que des pistes conductrices 110 et une puce électronique 120, sur l'autre (appelée « face arrière » ou « face bonding »). La fixation de la puce électronique 120 sur le substrat 101 est réalisée par au moins une technique connue telle que le fixage de puce (« die-attach » selon la terminologie anglo-saxonne) et sa connexion électrique aux contacts 102 et aux pistes conductrices 110 est réalisée par au moins une technique connue telle que la technologie de la puce retournée (« flip-chip » selon la technologie anglo-saxonne), la soudure de fils (« wire-bonding » selon la terminologie anglo-saxonne), etc. La puce 120 et ses éventuelles connexions par fils aux contacts 102 et aux pistes conductrices 110 sont avantageusement protégées par encapsulation dans une résine (« globe top » ou « dam&fill » selon la terminologie anglo-saxonne, correspondant à une encapsulation UV ou thermique). La puce étant placée sur la face arrière du substrat ou dans une découpe réalisée dans celle-ci, l'encapsulation est réalisée à partir de cette face arrière et peut former une surépaisseur par rapport à cette celle-ci, sur une certaine zone que l'on nommera par la suite « zone d'encapsulation ».

L'antenne 200 est également réalisée, par exemple de manière connue, sur un substrat double face avec des puits de connexion métallisés entre les extrémités de l'antenne sur une face du support 210 et des plots de connexion 220 réalisés sur l'autre face (voir Fig. 3 - en transparence, c'est-à-dire en représentant les motifs présents sur les deux faces du support 210). Le support 210 de l'antenne 200 est en matière plastique et plus particulièrement en PVC par exemple.

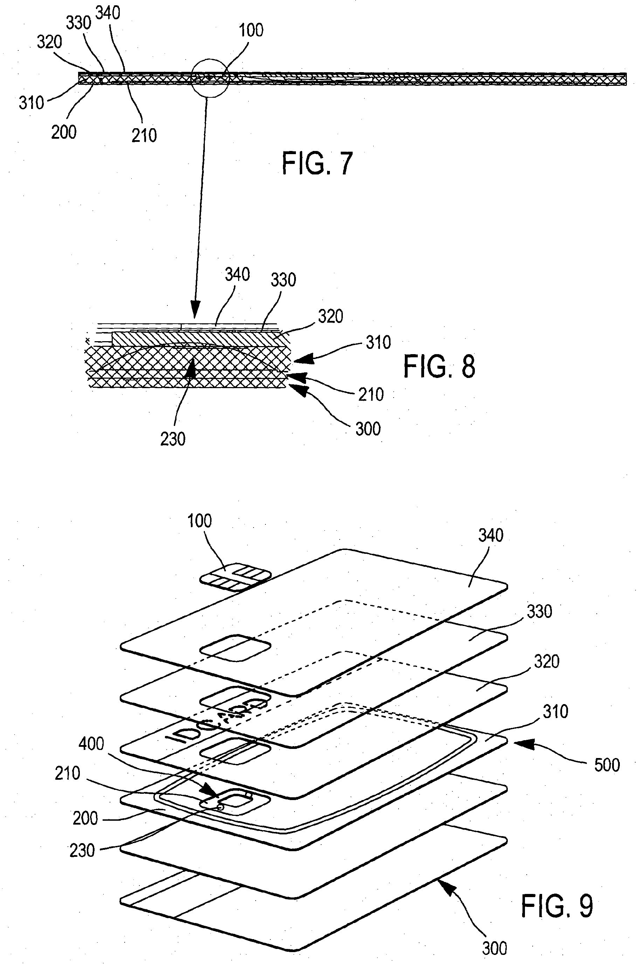

Un matériau de soudure 230, par exemple sous forme de goutte de soudure, est disposé sur chacun des plots de connexion 220 de l'antenne. Chaque goutte de matériau de soudure 230, une fois déposée sur un plot de connexion 220 et avant l'opération de chauffage pour réaliser la soudure entre l'antenne 200 et le module 100, forme un dôme ayant une hauteur comprise entre 0,02 et 0,5 mm. Avantageusement, comme on peut le voir sur la figure 8, chaque goutte de matériau de soudure 230, avant chauffage, dépasse de la surface de la cavité 400. En effet, chaque goutte de matériau de soudure 230, au cours du chauffage, doit venir au contact des pistes conductrices 110. La mouillabilité du matériau de soudure fondu peut éventuellement suffire pour établir le contact, même dans les cas où une goutte de matériau de soudure ne ferait qu'affleurer à la surface de la cavité sur laquelle le module 400 vient s'appuyer. Cependant, on peut éviter un contact insuffisant ou défaillant du fait d'une mouillabilité insuffisante en adaptant la hauteur de chaque goutte de matériau de soudure 230 de manière à ce que cette hauteur soit supérieure à au moins l'épaisseur de la couche (ou éventuellement de plusieurs couches) qui sera (seront) déposée(s) sur le support 210 d'antenne et en vis-à-vis de laquelle (desquelles) seront positionnées les pistes conductrices 110. Cette caractéristique est particulièrement avantageuse, lorsque le module 100 est fixé dans sa cavité à l'aide d'un adhésif thermoréactivable qui peut former une surépaisseur gênant ou empêchant la mise en contact d'une goutte de matériau de soudure 230 avec la piste conductrice 110 à laquelle elle doit être connectée.

Puis, le support 210 d'antenne est laminé entre des couches de matière plastique (PVC par exemple) 300, 310, 320, 330, 340 en laissant dégagées des cavités 400 dans chacune desquelles un module 100 peut être logé. Chaque cavité 400 est telle que les plots de connexion de l'antenne et ses gouttes de matériau de soudure 230 restent accessibles (Fig. 4 et 5).

Les différentes couches de matière plastique sont par exemple (voir également les figures 7 et 8) :
- une couche inférieure (ou éventuellement plusieurs couches inférieures) de finition (d'impression par exemple) et de protection 300 de la carte, situées sous le support 210 ; l'épaisseur de cette couche inférieure en PVC est par exemple de 0,1 mm d'épaisseur après lamination ; cette couche ne comporte pas de découpe destiné à réaliser la cavité 400 pour recevoir un module ;
- une couche d'entretoise 310, en PVC de 0,4 mm d'épaisseur après lamination par exemple, située sur le support 210; cette couche d'entretoise 310 comporte une découpe correspondant à une cavité 400 ;
- une couche d'impression 320, en PVC de 0,1 mm d'épaisseur après lamination par exemple, sur laquelle figurent des décorations destinées à être visibles sur la carte, située sur la couche d'entretoise 310 et comportant également une découpe correspondant à une cavité 400 ;
- une première couche de finition 330, en PVC, de 0,05 mm d'épaisseur après lamination, située au-dessus de la couche d'impression 320 et ; cette première couche de finition 330 comporte une découpe correspondant à une cavité 400 ;
- une deuxième couche supérieure de finition et de protection 340, en PVC, également de 0,05 mm d'épaisseur après lamination et située sur la première couche de finition 330 ; cette deuxième couche supérieure de finition et de protection 340 comporte une découpe correspondant à une cavité 400.

L'épaisseur totale de l'ensemble des couches 300-340, et donc de la carte est sensiblement de 0,7 mm après lamination.

Alternativement, plutôt que de réaliser les découpes dans les différentes couches 310, 320, 330, 340 laminées au-dessus du support 210 de l'antenne 200 pour réaliser la cavité 400, la cavité 400 est fraisée avant connexion et fixation du module 100 dans la cavité 400.

Un module 100 est ensuite placé dans chaque cavité 400 de manière à ce que deux pistes de connexion 110 dédiées à la connexion d'une antenne 200 à une puce 120 se trouvent chacune en vis-à-vis d'un plot de connexion 220.

Les zones du module 100 de trouvant au niveau des gouttes de matériau de soudure 230 sont ensuite chauffées pour faire fondre le matériau de soudure 230 et souder les plots de connexion 220 de l'antenne 200 à ces pistes de connexion 110. Cette opération de chauffage est effectuée par exemple en même temps que celle consistant à faire chauffer les points d'adhésif thermo-réactivable permettant de coller chaque module 100 dans sa cavité 400. Ces points d'adhésif thermo-réactivable sont en effet très proches des gouttes de matériau de soudure 230 placées sur les plots de connexion 220 de l'antenne 200. Les deux peuvent donc être éventuellement chauffés lors de la même opération. En choisissant un matériau de soudure 230 ayant une température de fusion comprise entre 120°C et 230°C, et plus préférentiellement entre 160°C et 190°C, on peut réaliser l'opération de chauffage du matériau de soudure 230 est en appliquant, avec une thermode par exemple, sur une zone du module 100, une température comprise entre 120°C et 250°C.

Du fait de l'épaisseur du module 100 et de la hauteur du dôme d'une goutte de matériau de soudure 230, lorsque le matériau de soudure fond, il vient mouiller le plot de connexion 220 correspondant (voir figure 8).

La figure 9 montre une structure 500 pour carte à puce comportant une antenne 200 insérée, telle quelle ou reposant sur un support, déjà laminée pour former un produit prêt à être encarté, par lamination entre des couches d'impression et de finition identiques ou similaires à celles déjà décrites.

Cette structure 500 comporte des gouttes de matériau de soudure 230 au niveau des plots de connexion de l'antenne 200, ainsi qu'une ouverture (fraisée ou préalablement découpée dans les différentes couches 310, 320, 330, 340) destinée à la réalisation de la cavité 400. Lorsque la cavité 400 est fraisée, avantageusement, les différentes couches 310, 320, 330, 340 sont laminées au-dessus du support 210 de l'antenne 200, sans découpe correspondant à la cavité 400. Le fraisage de la cavité 400 est en effet réalisé à travers ces différentes couches 310, 320, 330, 340 laminées, avant connexion et fixation du module 100 dans la cavité 400 ainsi fraisée. En variante, on peut réaliser une structure similaire à partir d'une antenne filaire insérée dans un support (par exemple par une technique de « wire embedding »). Les extrémités de cette antenne comportent des plots qui reçoivent des gouttes de matériau de soudure permettant de souder les extrémités de cette antenne à des pistes conductrices du module.

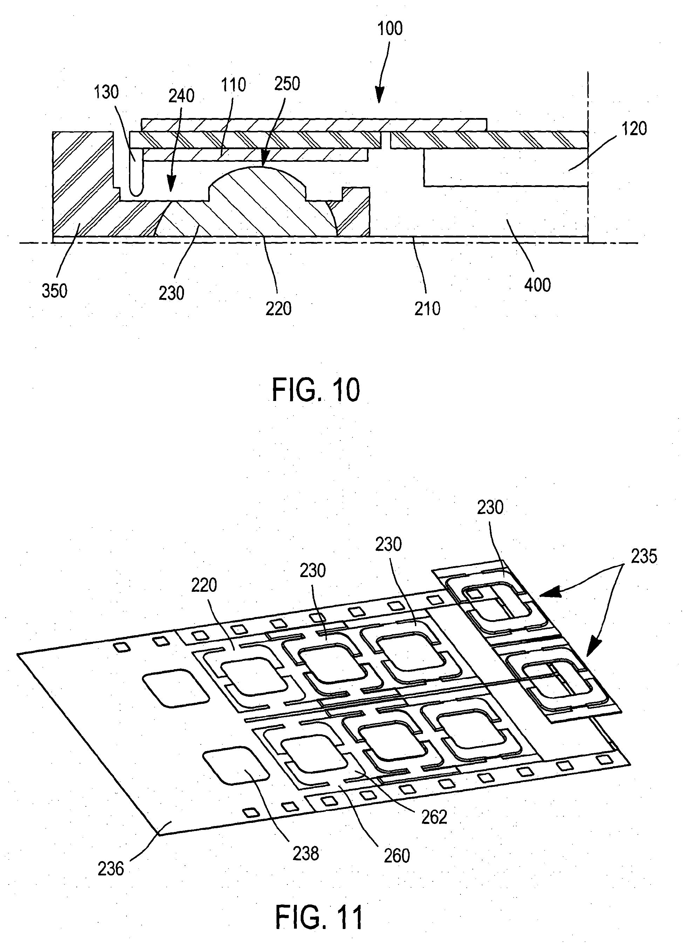

Selon une autre variante illustrée par la figure 10, une goutte de matériau de soudure 230 est disposée sur chacun des plots de connexion 220 de l'antenne, comme décrit ci-dessus. Puis, le support 210 d'antenne est laminé entre différentes couches 350 de matière plastique (PVC par exemple), puis la cavité 400 dans laquelle un module 100 peut être logé est fraisée. Ce fraisage permet non seulement de réaliser les différentes parties de la cavité 400 destinées, non-seulement, à d'une part, accommoder la puce 120, éventuellement encapsulée avec ses connexions filaires (non-représentées), et d'autre part, former les surfaces destinées à adhérer avec un adhésif thermo-réactivable 130 pour la fixation du module 100 dans la cavité 400, mais aussi à dégager une partie de chaque goutte de matériau de soudure 230, du matériau plastique formant les différentes couches 350 entre lesquelles le support 210 d'antenne a été inséré puis laminé. Le fraisage est réalisé en profondeur, sur au moins une partie du pourtour du matériau de soudure 230, pour dégager le matériau de soudure 230 des couches 350 laminées au-dessus du support 210, mais également de manière à ce que le matériau de soudure 230 dépasse (avant chauffage) au-dessus de la surface de la cavité 400. Par exemple, une gorge 240 est formée au cours du fraisage, autour de chaque goutte de matériau de soudure 230 (ou au moins au moins sur une partie du pourtour ce chacune d'elle). Ainsi, le fond de cette gorge 240 se situe sous le niveau supérieur 250 de cette goutte de matériau de soudure. Par exemple, la gorge a une profondeur comprise entre 20 et 200 µm.

Avantageusement, lors du fraisage de la cavité 400, une partie de chaque goutte de matériau de soudure 230 est ôtée, pour s'assurer que le matériau plastique dans lequel est réalisé le fraisage n'empêchera, ni ne rapprochement des surfaces à souder, ni le matériau formant les gouttes de matériau de soudure 230 en fusion de mouiller les pistes conductrices 110. Ainsi, par exemple, le fraisage est réalisé de manière circulaire tout autour de chaque goutte de matériau de soudure 230.

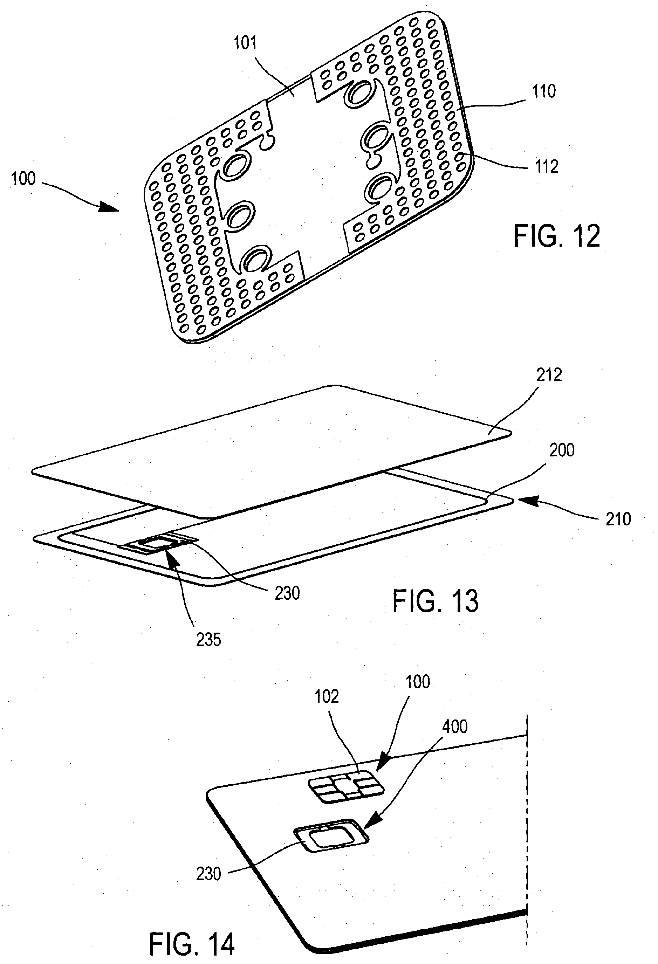

Selon un mode de mise en œuvre du procédé de fabrication de carte à puce selon l'invention, illustré par les figures 11 à 14, on réalise d'une part, des modules 100 (Figure 12), et d'autre part, des antennes 200 sur un support 210 (Figure 13). Par ailleurs, on réalise aussi des unités de soudure 235 (Figure 11).

Comme illustré sur la figure 11, les unités de soudure 235 sont réalisées (par exemple en continu, de bobine à bobine), à partir d'un film flexible 236 (par exemple de type stratifié cuivré - « copper clad » selon la terminologie anglo-saxonne). Ce film flexible comporte une couche conductrice sur une face. Ce film flexible est découpé (par exemple par poinçonnage) pour former des ouvertures 238 destinées à recevoir la résine d'encapsulation d'un module 100 Des crans d'entrainement sont également découpés. La couche conductrice est ensuite gravée (par exemple selon des techniques de photolithogravure) pour former des plots de connexion 220 (deux plots de connexion 220 par unité de soudure 235). Chaque plot de connexion 220 comporte une zone métallisée avec une première 260 et une deuxième 262 portions. La première portion 260 a une forme essentiellement rectangulaire. La deuxième portion 262 a une forme de U s'étendant autour des ouvertures 238, avec le fond du U relié (connecté) essentiellement au milieu de la première portion considérée selon sa direction longitudinale. Du matériau de soudure 230 est ensuite déposé sur les plots de connexion 220 par exemple sur une épaisseur comprise par exemple entre 0, 02 à 0,5mm. Le matériau de soudure est ôté des premières portions 260. Enfin les unités de soudure 235 sont découpées pour être individualisées.

Comme illustré sur la figure 12, des structures d'accrochage 112 sont réalisée sur la face arrière du module 100, sur les pistes de connexion 110 (le module 100 est ici représenté sans la puce, les fils de connexion et la résine d'encapsulation). Ces structures d'accrochage 112 comprennent par exemple des trous ronds réalisés par gravure dans les pistes conductrices 110. De nombreuses autres formes peuvent bien entendu être envisagées (carrés, triangles, forme quelconque, etc.). Chaque piste conductrice 110 s'étend en forme de U partiellement autour de la zone destinée à recevoir la puce, les fils de connexion et la résine d'encapsulation.

Par ailleurs, comme représenté sur la figure 13, une antenne 200 métallique, est gravée ou déposée (par « wire embedding » par exemple) sur un support 210 isolant.

Une unité de soudure 235 est placée (et éventuellement collée) sur ou dans le support 210 et les extrémités de l'antenne 200 sont connectées (par exemple par thermocompression) aux premières portions 260 des plots de connexion 220. Cet ensemble, constitué de l'antenne 200 et de l'unité de soudure 235 sur leur support 210, est recouvert d'une couche matériau plastique 212. Cette structure (l'antenne 200, l'unité de soudure 235, le support 210 et la couche 212) constitue en support d'antenne qui peut être vendu pour être inséré dans une structure multicouche plus complexe destinée à la réalisation d'une carte à puce.

Ainsi, par exemple après insertion de cette structure dans un complexe multicouche tel que celui décrit en relation avec la figure 9 (dans ce cas, la structure comprenant l'antenne 200, le support 210 et la couche 212, remplace la structure 500) une cavité 400 est fraisée (voir figure 14), pour y loger un module 100. Le fraisage peut être réalisé de manière similaire au procédé décrit en relation avec la figure 10.

Les premières portions 260 des plots de connexion 220, sur lesquelles ont été connectées les extrémités de l'antenne 200, se trouvent hors de la zone fraisée et restent protégées par la couche 212 et les couches laminées sur celle-ci. Seules les deuxièmes portions 262 des plots de connexion 220 recouvertes du matériau de soudure sont accessibles dans la cavité 400 après fraisage. Une fois le module 100 logé dans la cavité 400, les pistes conductrices 110 et leurs structures d'accrochage 112 se trouvent en vis-à-vis du matériau de soudure 230 déposé sur les deuxièmes portions 262 des plots de connexion 220.

Une thermode est ensuite appliquée sur la face avant du module 100 pour faire fondre le matériau de soudure 230 entre les pistes conductrices 110 et les plots de connexion 220.

La surface respective des pistes conductrices 110 (sans considérer les trous des structures d'accrochage 112) et des plots de connexion 220 est par exemple comprise entre 2 et 20mm², mais on comprend qu'une plage de matériau de soudure 230 avec une surface s'approchant ou voisine de 20mm² peut permettre une fixation plus solide du module 100 dans la cavité 400, mais la quantité de matériau de soudure à faire fondre étant plus importante, il faut apporter plus de chaleur.

Les trous des structures d'accrochage 112 ont par exemple un diamètre compris entre 0,1 et 2 mm.

Ainsi, on obtient une force d'arrachement du module 100 suffisamment élevée, pour répondre aux spécifications de ce type de produit. Le matériau de soudure 230 permet ainsi de non seulement d'établir une connexion électrique entre les pistes conductrices 110 et les plots de connexion 220, mais également de fixer le module 100 dans la cavité 400 sans l'aide d'autre adhésif.

## Revendications

1. Procédé de fabrication d'une carte à puce, comprenant :
- la réalisation d'un module (100) de carte à puce comportant un substrat (101) ayant une première et une deuxième faces principales, avec sur la première face du substrat, des contacts (102) pour une connexion électrique temporaire avec un dispositif de lecture à contacts de carte, et sur la deuxième face du substrat, des pistes conductrices (110), ce module étant également muni d'une puce électronique (120) connectée à au moins certains contacts (102) et à au moins deux pistes conductrices dédiées à une connexion d'antenne,
- la réalisation d'une antenne (200) sur un support d'antenne (210) pour un couplage électromagnétique avec un dispositif de lecture sans contact de carte, l'antenne (200) comportant deux extrémités et un plot de connexion (220) respectivement à chacune de ses extrémités,
- la lamination du support d'antenne (210) entre des couches de matière plastique (300-340), et
- la mise en place du module (100) dans une cavité (400) ménagée dans au moins certaines des couches de matière plastique (310-340),
- une étape de dépôt d'un matériau de soudure (230) sur chacun des plots de connexion (220) de l'antenne (200) et le chauffage, une fois le module en place dans la cavité (400), du matériau de soudure (230) déposé sur les plots de connexion (220), afin de souder chacune des pistes conductrices (110) du module (100) dédiées à une connexion d'antenne, respectivement avec un plot de connexion (220),
**caractérisé par le fait que** l'on utilise une unité de soudure (235) individualisée et placée sur ou dans le support d'antenne (210), cette unité de soudure comprenant un film flexible (236) sur lequel sont formés les plots de connexion (220) auxquels sont connectées les extrémités de l'antenne (200).

2. Procédé selon la revendication 1, dans lequel l'unité de soudure (235) est placée sur le support d'antenne (210).

3. Procédé selon la revendication 1, dans lequel l'unité de soudure (235) est placée dans le support d'antenne (210).

4. Procédé selon l'une des revendications précédentes, dans lequel chaque plot de connexion (220) de l'antenne (200) comporte une zone métallisée avec une première (260) et une deuxième (262) portions, et dans lequel on connecte l'antenne (200) à la première portion (260) et le matériau de soudure est déposé sur la deuxième portion (262).

5. Procédé selon l'une des revendications précédentes, dans lequel le matériau de soudure (230) sur chacun des plots de connexion (220) de l'antenne (200) dépasse, avant son chauffage, de la surface de la cavité (400).

6. Procédé selon l'une des revendications précédentes, dans lequel la cavité (400) ménagée dans au moins certaines des couches de matière plastique (310-340) est fraisée en réalisant au moins une gorge associée à un plot de connexion (220), dont le fond se situe sous le niveau supérieur (250) du matériau de soudure déposé sur ce plot de connexion (220).

7. Procédé selon la revendication 6, dans lequel la gorge reçoit un matériau de collage du module (100) dans la cavité (400).

8. Procédé selon l'une des revendications 6 et 7, dans lequel la gorge a une profondeur comprise entre 20 et 200 µm.

9. Procédé selon l'une des revendications précédentes, dans lequel le matériau de soudure (230), sur chacun des plots de connexion (220) de l'antenne (200), est déposé sous forme d'une plage dont la surface est au moins égale à 2 mm².

10. Procédé selon l'une des revendications précédentes, dans lequel les pistes conductrices (110) dédiées à une connexion d'antenne (200) comportent des structures d'accrochage (112).

11. Procédé selon l'une des revendications précédentes, dans lequel le matériau de soudure (230) est constitué d'un matériau ayant une température de fusion comprise entre 120°C et 230°C, et plus préférentiellement entre 160°C et 190°C.

12. Procédé selon l'une des revendications précédentes, dans lequel le chauffage du matériau de soudure (230) est réalisé en appliquant sur une zone du module (100) une température comprise entre 120°C et 250°C.

13. Procédé selon l'une des revendications précédentes, dans lequel le support d'antenne (210) comporte un substrat de PVC.

14. Procédé selon l'une des revendications précédentes, dans lequel les couches de matière plastique sont en PVC.

15. Support d'antenne pour carte à puce, le support comprenant une antenne (200) permettant un couplage électromagnétique avec un dispositif de lecture sans contact de carte, l'antenne (200) comportant deux extrémités, un plot de connexion (220) respectivement à chacune de ses extrémités, et un matériau de soudure (230) sur chacun des plots de connexion (220),
**caractérisé par le fait que** le support comprend une unité de soudure (235) individualisée comprenant un film flexible (236) sur lequel sont formés les plots de connexion (220) auxquels sont connectées les extrémités de l'antenne (200).

16. Support d'antenne selon la revendication 15, dans lequel l'épaisseur du matériau de soudure (230) est comprise entre 0,02 et 0,5 mm.

17. Support d'antenne selon la revendication 15 ou 16, dans lequel le matériau de soudure (230) sur chacun des plots de connexion (220) de l'antenne (200) forme une plage de soudure dont la surface est au moins égale à 2mm².

18. Support d'antenne selon l'une des revendications 15 à 17, dans lequel le matériau de soudure (230) est constitué d'un alliage d'étain-bismuth.

19. Support d'antenne selon l'une des revendications 15 à 18, comportant un substrat de PVC.

20. Carte à puce comportant
- un module (100) de carte à puce comportant un substrat (101) ayant une première et une deuxième faces principales, avec sur la première face du substrat (101), des contacts (102) pour une connexion électrique temporaire avec un dispositif de lecture de carte à contacts, et sur la deuxième face, des pistes conductrices (110), ce module (100) étant également muni d'une puce électronique (120) connectée à au moins certains contacts (102) et à au moins deux pistes conductrices (110) dédiées à une connexion d'antenne,
- une antenne (200) sur un support (210) d'antenne pour un couplage électromagnétique avec un dispositif de lecture sans contact de cartes, l'antenne (200) comportant deux extrémités et un plot de connexion (220) respectivement à chacune de ses extrémités,
- le support (210) d'antenne étant laminé entre des couches de matière plastique (300-340),
- le module (100) étant logé dans une cavité (400) ménagée dans au moins certaines des couches de matière plastique (310-340), et
- chacune des deux pistes conductrices (110) dédiées à une connexion d'antenne étant soudée à chacun des plots de connexion (220) de l'antenne, à l'aide d'un matériau de soudure (230),
**caractérisée par le fait que** la carte comprend une unité de soudure individualisée, placée sur ou dans le support d'antenne (210), l'unité de soudure comprenant un film flexible (236) sur lequel sont formés les plots de connexion (220) auxquels sont connectées les extrémités de l'antenne (200).

21. Carte à puce selon la revendication 20, dans laquelle le matériau de soudure (230) a une température de fusion comprise entre 120°C et 230°C, et plus préférentiellement entre 160°C et 190°C.

22. Carte à puce selon la revendication 21, dans laquelle le matériau de soudure a une épaisseur comprise entre 0,02 et 0,5 mm.

23. Carte à puce selon la revendication 21 ou 22, dans laquelle le matériau de soudure est constitué d'un alliage d'étain-bismuth.

24. Carte à puce selon l'une des revendications 21 à 23, dans laquelle le matériau de soudure (230) sur chacun des plots de connexion (220) de l'antenne (200) forme une plage dont la surface est au moins égale à 2mm².

25. Carte à puce selon l'une des revendications 21 à 24, dans laquelle le matériau de soudure (230) sur chacun des plots de connexion (220) de l'antenne (200) s'étend en forme de U autour d'un espace creux (138).

26. Carte à puce selon l'une des revendications 21 à 25, dans laquelle chaque plot de connexion (220) de l'antenne (200) comporte une zone métallisée avec une première (260) et une deuxième (262) portions, et dans laquelle l'antenne est connectée à la première portion (260) et le module est connecté à la deuxième portion (262) par l'intermédiaire du matériau de soudure (230).

27. Carte à puce selon la revendication 26, dans laquelle les pistes conductrices (110) dédiées à une connexion d'antenne comportent des structures d'accrochage (112) en regard de la deuxième portion (262).

28. Carte à puce selon l'une des revendications 20 à 27, dans laquelle le support d'antenne comporte un substrat de PVC.

## Patentansprüche

1. Verfahren zur Herstellung einer Chipkarte, umfassend:
- die Ausführung eines Chipkartenmoduls (100), das ein Substrat (101) beinhaltet, das eine erste und eine zweite Hauptseite aufweist, mit Kontakten (102) auf der ersten Seite des Substrats für eine vorübergehende elektrische Verbindung mit einem kontaktbehafteten Kartenlesegerät und Leiterbahnen (110) auf der zweiten Seite des Substrats, wobei dieses Modul auch mit einem elektronischen Chip (120) versehen ist, der mit mindestens einigen Kontakten (102) und mit mindestens zwei für eine Antennenverbindung bestimmten Leiterbahnen verbunden ist,
- die Ausführung einer Antenne (200) auf einem Antennenträger (210) für eine elektromagnetische Kopplung mit einem kontaktlosen Kartenlesegerät, wobei die Antenne (200) zwei Enden und jeweils ein Anschlusspad (220) an jedem ihrer Enden beinhaltet,
- das Laminieren des Antennenträgers (210) zwischen Kunststoffschichten (300-340) und
- das Einsetzen des Moduls (100) in eine Ausnehmung (400), die in mindestens einigen der Kunststoffschichten (310-340) ausgebildet ist,
- einen Schritt des Aufbringens eines Lötmaterials (230) auf jedes der Anschlusspads (220) der Antenne (200) und das Erhitzen, nachdem das Modul in die Ausnehmung (400) eingesetzt wurde, des auf die Anschlusspads (220) aufgebrachten Lötmaterials (230), um jede der für eine Antennenverbindung bestimmten Leiterbahnen (110) des Moduls (100) mit jeweils einem Anschlusspad (220) zu verlöten,
**dadurch gekennzeichnet, dass** eine individualisierte und auf oder in dem Antennenträger (210) angeordnete Löteinheit (235) verwendet wird, wobei diese Löteinheit eine flexible Folie (236) umfasst, auf der die Anschlusspads (220) gebildet sind, mit denen die Enden der Antenne (200) verbunden werden.

2. Verfahren nach Anspruch 1, bei dem die Löteinheit (235) auf dem Antennenträger (210) angeordnet ist.

3. Verfahren nach Anspruch 1, bei dem die Löteinheit (235) in dem Antennenträger (210) angeordnet ist.

4. Verfahren nach einem der vorhergehenden Ansprüche, bei dem jedes Anschlusspad (220) der Antenne (200) eine metallisierte Zone mit einem ersten (260) und einem zweiten (262) Abschnitt aufweist und bei dem die Antenne (200) mit dem ersten Abschnitt (260) verbunden wird und das Lötmaterial auf den zweiten Abschnitt (262) aufgebracht wird.

5. Verfahren nach einem der vorhergehenden Ansprüche, bei dem das Lötmaterial (230) auf jedem der Anschlusspads (220) der Antenne (200) vor seinem Erhitzen die Oberfläche der Ausnehmung (400) überragt.

6. Verfahren nach einem der vorhergehenden Ansprüche, bei dem die in mindestens einigen der Kunststoffschichten (310-340) ausgebildete Ausnehmung (400) gefräst wird, wobei mindestens eine einem Anschlusspad (220) zugeordnete Rille ausgeführt wird, deren Boden unter der oberen Höhe (250) des auf dieses Anschlusspad (220) aufgebrachten Lötmaterials liegt.

7. Verfahren nach Anspruch 6, bei dem die Rille ein Material zum Kleben des Moduls (100) in die Ausnehmung (400) aufnimmt.

8. Verfahren nach einem der Ansprüche 6 und 7, bei dem die Rille eine Tiefe zwischen 20 und 200 µm aufweist.

9. Verfahren nach einem der vorhergehenden Ansprüche, bei dem das Lötmaterial (230) auf jedes der Anschlusspads (220) der Antenne (200) in Form eines Bereichs mit einer Fläche von mindestens 2 mm² aufgebracht wird.

10. Verfahren nach einem der vorhergehenden Ansprüche, bei dem die für eine Antennenverbindung (200) bestimmten Leiterbahnen (110) Festhaltestrukturen (112) beinhalten.

11. Verfahren nach einem der vorhergehenden Ansprüche, bei dem das Lötmaterial (230) aus einem Material besteht, das eine Schmelztemperatur zwischen 120 °C und 230 °C und weiter bevorzugt zwischen 160 °C und 190 °C hat.

12. Verfahren nach einem der vorhergehenden Ansprüche, bei dem das Erhitzen des Lötmaterials (230) ausgeführt wird, indem auf eine Zone des Moduls (100) eine Temperatur zwischen 120 °C und 250 °C angewandt wird.

13. Verfahren nach einem der vorhergehenden Ansprüche, bei dem der Antennenträger (210) ein Substrat aus PVC beinhaltet.

14. Verfahren nach einem der vorhergehenden Ansprüche, bei dem die Kunststoffschichten aus PVC sind.

15. Antennenträger für eine Chipkarte, wobei der Träger eine Antenne (200) umfasst, die eine elektromechanische Kopplung mit einem kontaktlosen Kartenlesegerät ermöglicht, wobei die Antenne (200) zwei Enden und jeweils ein Anschlusspad (220) an jedem ihrer Enden und ein Lötmaterial (230) auf jedem der Anschlusspads (220) beinhaltet, **dadurch gekennzeichnet, dass** der Träger eine individualisierte Löteinheit (235) umfasst, die eine flexible Folie (236) umfasst, auf der die Anschlusspads (220) gebildet sind, mit denen die Enden der Antenne (200) verbunden werden.

16. Antennenträger nach Anspruch 15, bei dem die Dicke des Lötmaterials (230) zwischen 0,02 und 0,5 mm beträgt.

17. Antennenträger nach Anspruch 15 oder 16, bei dem das Lötmaterial (230) auf jedem der Anschlusspads (220) der Antenne (200) einen Lötbereich bildet, dessen Fläche mindestens 2 mm² beträgt.

18. Antennenträger nach einem der Ansprüche 15 bis 17, bei dem das Lötmaterial (230) aus einer Zinn-Bismut-Legierung besteht.

19. Antennenträger nach einem der Ansprüche 15 bis 18, der ein Substrat aus PVC beinhaltet.

20. Chipkarte, die beinhaltet
- ein Chipkartenmodul (100), das ein Substrat (101) beinhaltet, das eine erste und eine zweite Hauptseite aufweist, mit Kontakten (102) auf der ersten Seite des Substrats (101) für eine vorübergehende elektrische Verbindung mit einem kontaktbehafteten Kartenlesegerät und Leiterbahnen (110) auf der zweiten Seite, wobei dieses Modul (100) auch mit einem elektronischen Chip (120) versehen ist, der mit mindestens einigen Kontakten (102) und mit mindestens zwei für eine Antennenverbindung bestimmten Leiterbahnen (110) verbunden ist,
- eine Antenne (200) auf einem Antennenträger (210) für eine elektromagnetische Kopplung mit einem kontaktlosen Kartenlesegerät, wobei die Antenne (200) zwei Enden und jeweils ein Anschlusspad (220) an jedem ihrer Enden beinhaltet,
- wobei der Antennenträger (210) zwischen Kunststoffschichten (300-340) laminiert ist,
- wobei das Modul (100) in einer Ausnehmung (400) aufgenommen ist, die in mindestens einigen der Kunststoffschichten (310-340) ausgebildet ist, und
- wobei jede der beiden für eine Antennenverbindung bestimmten Leiterbahnen (110) mit einem der Anschlusspads (220) der Antenne mithilfe eines Lötmaterials (230) verlötet ist,
**dadurch gekennzeichnet, dass** die Karte eine individualisierte Löteinheit umfasst, die auf oder in dem Antennenträger (210) angeordnet ist, wobei die Löteinheit eine flexible Folie (236) umfasst, auf der die Anschlusspads (220) gebildet sind, mit denen die Enden der Antenne (200) verbunden werden.

21. Chipkarte nach Anspruch 20, bei der das Lötmaterial (230) eine Schmelztemperatur zwischen 120 °C und 230 °C und weiter bevorzugt zwischen 160 °C und 190 °C hat.

22. Chipkarte nach Anspruch 21, bei der das Lötmaterial eine Dicke zwischen 0,02 und 0,5 mm hat.

23. Chipkarte nach Anspruch 21 oder 22, bei der das Lötmaterial aus einer Zinn-Bismut-Legierung besteht.

24. Chipkarte nach einem der Ansprüche 21 bis 23, bei der das Lötmaterial (230) auf jedem der Anschlusspads (220) der Antenne (200) einen Bereich mit einer Fläche von mindestens 2 mm² bildet.

25. Chipkarte nach einem der Ansprüche 21 bis 24, bei der sich das Lötmaterial (230) auf jedem der Anschlusspads (220) der Antenne (200) U-förmig um einen Hohlraum (138) herum erstreckt.

26. Chipkarte nach einem der Ansprüche 21 bis 25, bei der jedes Anschlusspad (220) der Antenne (200) eine metallisierte Zone mit einem ersten (260) und einem zweiten (262) Abschnitt aufweist und bei der die Antenne mit dem ersten Abschnitt (260) verbunden ist und das Modul mittels des Lötmaterials (230) mit dem zweiten Abschnitt (262) verbunden ist.

27. Chipkarte nach Anspruch 26, bei der die für eine Antennenverbindung bestimmten Leiterbahnen (110) Festhaltestrukturen (112) gegenüber dem zweiten Abschnitt (262) beinhalten.

28. Chipkarte nach einem der Ansprüche 20 bis 27, bei der der Antennenträger ein Substrat aus PVC beinhaltet.

## Claims

1. Method for manufacturing a chip card, comprising:
- the production of a chip card module (100) comprising a substrate (101) having a first and a second main faces, with, on the first face of the substrate, contacts (102) for a temporary electrical connection with a reading device with card contacts, and, on the second face of the substrate, conductive tracks (110), this module being also provided with an electronic chip (120) connected to at least some contacts (102) and to at least two conductive tracks dedicated to an antenna connection,
- the production of an antenna (200) on an antenna support (210) for an electromagnetic coupling with a reading device without card contact, the antenna (200) comprising two ends and a connection area (220) respectively at each of its ends,
- the lamination of the antenna support (210) between layers of plastic material (300-340), and
- the placement of the module (100) in a cavity (400) formed in at least some of the layers of plastic material (310-340),
- a step of deposition of a solder material (230) on each of the connection areas (220) of the antenna (200) and the heating, once the module is in place in the cavity (400), of the solder material (230) deposited on the connection areas (220), in order to solder each of the conductive tracks (110) of the module (100) that are dedicated to an antenna connection, respectively with a connection area (220),
**characterized in that** a soldering unit (235) is used that is individualized and placed on or in the antenna support (210), this soldering unit comprising a flexible film (236) on which are formed the connection areas (220) to which the ends of the antenna (200) are connected.

2. Method according to Claim 1, wherein the soldering unit (235) is placed on the antenna support (210).

3. Method according to Claim 1, wherein the soldering unit (235) is placed in the antenna support (210).

4. Method according to one of the preceding claims, wherein each connection area (220) of the antenna (200) comprises a metallized zone with a first (260) and a second (262) portions, and wherein the antenna (200) is connected to the first portion (260) and the solder material is deposited on the second portion (262).

5. Method according to one of the preceding claims, wherein the solder material (230) on each of the connection areas (220) of the antenna (200) extends, prior to the heating thereof, beyond the surface of the cavity (400).

6. Method according to one of the preceding claims, wherein the cavity (400) formed in at least some of the layers of plastic material (310-340) is milled by producing at least one groove associated with a connection area (220), the bottom of which is situated under the top level (250) of the solder material deposited on this connection area (220).

7. Method according to Claim 6, wherein the groove receives a material for bonding the module (100) in the cavity (400).

8. Method according to one of Claims 6 and 7, wherein the groove has a depth of between 20 and 200 µm.

9. Method according to one of the preceding claims, wherein the solder material (230), on each of the connection areas (220) of the antenna (200), is deposited in the form of a land whose surface area is at least equal to 2 mm².

10. Method according to one of the preceding claims, wherein the conductive tracks (110) dedicated to an antenna connection (200) comprise attachment structures (112).

11. Method according to one of the preceding claims, wherein the solder material (230) is composed of a material having a melting point of between 120°C and 230°C, and more preferentially between 160°C and 190°C.

12. Method according to one of the preceding claims, wherein the heating of the solder material (230) is performed by applying a temperature of between 120°C and 250°C to a zone of the module (100).

13. Method according to one of the preceding claims, wherein the antenna support (210) comprises a PVC substrate.

14. Method according to one of the preceding claims, wherein the layers of plastic material are made of PVC.

15. Antenna support for a chip card, the support comprising an antenna (200) allowing an electromagnetic coupling with a reading device without card contact, the antenna (200) comprising two ends, a connection area (220) respectively at each of its ends; and a solder material (230) on each of the connection areas (220), **characterized in that** the support comprises an individualized soldering unit (235) comprising a flexible film (236) on which are formed the connection areas (220) to which the ends of the antenna (200) are connected.

16. Antenna support according to Claim 15, wherein the thickness of the solder material (230) is between 0.02 and 0.5 mm.

17. Antenna support according to Claim 15 or 16, wherein the solder material (230) on each of the connection areas (220) of the antenna (200) forms a solder land whose surface area is at least equal to 2 mm².

18. Antenna support according to one of Claims 15 to 17, wherein the solder material (230) is composed of a tin-bismuth alloy.

19. Antenna support according to one of Claims 15 to 18, comprising a PVC substrate.

20. Chip card, comprising
- a chip card module (100) comprising a substrate (101) having a first and a second main faces, with, on the first face of the substrate (101), contacts (102) for a temporary electrical connection with a card reading device with contacts, and, on the second face, conductive tracks (110), this module (100) being also provided with an electronic chip (120) connected to at least some contacts (102) and to at least two conductive tracks (110) dedicated to an antenna connection,
- an antenna (200) on an antenna support (210) for an electromagnetic coupling with a reading device without card contacts, the antenna (200) comprising two ends and a connection area (220) respectively at each of its ends,
- the antenna support (210) being laminated between layers of plastic material (300-340),
- the module (100) being housed in a cavity (400) formed in at least some of the layers of plastic material (310-340), and
- each of the two conductive tracks (110) dedicated to an antenna connection being soldered to one of the connection areas (220) of the antenna, using a solder material (230),
**characterized in that** the card comprises an individualized solder unit, placed on or in the antenna support (210), the solder unit comprising a flexible film (236) on which are formed the connection areas (220) to which the ends of the antenna (200) are connected.

21. Chip card according to Claim 20, wherein the solder material (230) has a melting point of between 120°C and 230°C, and more preferentially between 160°C and 190°C.

22. Chip card according to Claim 21, wherein the solder material has a thickness of between 0.02 and 0.5 mm.

23. Chip card according to Claim 21 or 22, wherein the solder material is composed of a tin-bismuth alloy.

24. Chip card according to one of Claims 21 to 23, wherein the solder material (230) on each of the connection areas (220) of the antenna (200) forms a land whose surface area is at least equal to 2 mm².

25. Chip card according to one of Claims 21 to 24 wherein the solder material (230) on each of the connection areas (220) of the antenna (200) extends in the form of a U around a hollow space (138).

26. Chip card according to one of Claims 21 to 25, wherein each connection area (220) of the antenna (200) comprises a metallized zone with a first (260) and a second (262) portions, and wherein the antenna is connected to the first portion (260) and the module is connected to the second portion (262) via the solder material (230).

27. Chip card according to Claim 26, wherein the conductive tracks (110) dedicated to an antenna connection comprise attachment structures (112) facing the second portion (262).

28. Chip card according to one of Claims 20 to 27, wherein the antenna support comprises a PVC substrate.
